**Europäisches Patentamt**

**European Patent Office**

**Office européen des brevets**

(19)

(11) Publication number: **0 021 473**
**B1**

# EUROPEAN PATENT SPECIFICATION

(12)

(45) Date of publication of patent specification: **12.01.83**

(51) Int. Cl.³: **G 02 B 5/14, H 01 L 33/00**

(21) Application number: **80200479.6**

(22) Date of filing: **22.05.80**

(54) **Coupling element comprising a light source and a lens-shaped element.**

(30) Priority: **31.05.79 NL 7904283**

(43) Date of publication of application:
**07.01.81 Bulletin 81/1**

(45) Publication of the grant of the patent:
**12.01.83 Bulletin 83/2**

(84) Designated Contracting States:
**CH DE FR GB LI NL SE**

(56) References cited:
**GB - A - 2 023 928**
**US - A - 3 805 347**
**US - A - 3 816 847**
**US - A - 3 880 528**

(73) Proprietor: **N.V. Philips' Gloeilampenfabrieken**
**Groenewoudseweg 1**
**NL-5621 BA Eindhoven (NL)**

(72) Inventor: **Kock, Hendrikus Gerardus**
**c/o INT. OCTROOIBUREAU B.V. Prof. Holstlaan 6**
**NL-5656 AA Eindhoven (NL)**

(74) Representative: **Faessen, Louis Marie et al,**
**INTERNATIONAAL OCTROOIBUREAU B.V. 6 Prof. Holstlaan**
**NL-5656 AA Eindhoven (NL)**

## Coupling element comprising a light source and a lens-shaped element

The invention relates to an optical coupling element, comprising a light source and a lens, the light source being mounted on a support on which a cover is secured, the lens being situated opposite the light source which emits a light beam in a direction transversely of the support.

A coupling element of this kind is described in a publication by Masayuki Abe et al in I.E.E.E. Transactions on Electron Devices, Vol. ED-24, No. 7, July 1977, pages 990—994. The described coupling element comprises a light-emitting diode, but could alternatively comprise a semiconductor laser. Furthermore, the lens is formed by an end of an optical fibre in which the light generated by the diode is radiated via the lens-shaped end. The coupling element shown is used in an optical communications system where data is transmitted by means of light pulses to be transmitted via optical fibres. However, besides said lens, the coupling element may also comprise further optical elements such as semi-transparent mirrors. A coupling element of this kind can be used, for example, in a video or audio disc/reading device (also referred as Video Long Play and Audio Long Play apparatus, respectively) in which the data stored on a disc is read by optical means. The optical means comprise at least said light source, the lens, a reflective surface of the video/audio disc, and a light detector. In order to realize an as effective as possible transmission of light to the optical element situated behind the lens, the lens should be situated in the correct position and at the correct distance with respect to the light source. Said publication describes the adjustment of the optical fibre to the LED.

During the adjustment, the amount of light radiated into the fibre via the lens-shaped end of the fibre is observed. The cover in which an optical fibre is secured by means of an epoxy resin is displaced with respect to the support until the amount of light observed in a given position is maximum. Subsequently, the cover is maintained in this position until the epoxy resin used for securing the cover to the support has set; this is a drawback in view of the time required for realizing a coupling element. Furthermore, the space between the cover and the support is contaminated by the solvents released during the setting of the epoxy resin. Consequently, an evacuated space or a space filled with an inert gas cannot be realized for the semiconductor light source. From the US—A— 3 816 847 a light-sensible semiconductor device is known which comprises a hermetic sealing case provided with a thin planar glass plate and a light converging lens attached onto the glass plate. In order to accurately align the optical axis of the lens and the semiconductor device a lens holder is provided to attach the lens to the glass plate securely in position without using a bonding material, but also to freely adjust the lens position within a certain extent.

The invention has for its object to provide a coupling element where the position and distance of the lens with respect to the light source can be very accurately and simply adjusted and maintained, without adhesive means such as epoxy resin being required, whilst the light source is enclosed in a hermetically sealed housing.

To this end, the coupling element in accordance with the invention is characterized in that the cover is shaped as a bush and is connected to the support by way of a metal joint and comprises a flange on which the lens or the flange of an annular metal holder on which the lens is mounted is secured by way of a plastic metal solder layer having a thickness of between 0.1 and 2 mm, the cover, the support and the lens or lens-holder assembly forming a hermetically sealed space.

After the manufacture of such a coupling element, the plastic solder layer enables positioning and distance adjustment of the lens with respect to the light source by displacement of the lens with respect to the cover, the solder layer then being plastically deformed and the coupling element being and remaining hermetically sealed. As a result, the coupling element can be advantageously manufactured in a dust free inert gas atmosphere or in vacuum, after which the lens can be adjusted with respect to the light source in an ambient atmosphere. The micromanipulators required for the adjustment, therefore, need not be situated in an inert gas atmosphere or in vacuum, so that the production means required for the coupling element do not differ from the production means used for the manufacture of conventional transistors and diodes.

The advantage of the embodiment comprising an annular metal holder consists in that the holder rather than the lens accommodated therein is mechanically loaded for the positioning of the lens, so that the risk of damaging of the lens during the described adjustment motions is reduced.

A preferred embodiment of a coupling element in accordance with the invention is characterized in that the annular holder comprises an annular protrusion on which the lens is mounted, the protrusion and the lens being situated between the flange of the cover and the support.

Because the holder and the lens are arranged completely within the bush-shaped cover, maladjustment of the positioning or the distance of the lens with respect to the light source, for example, due to collisions of the holder during use or further processing of the coupling element, is avoided in a coupling element of this kind.

Two embodiments in accordance with the invention will be described in detail hereinafter with reference to the accompanying diagrammatic drawing.

Fig. 1 shows an embodiment of an optical coupling element in accordance with the invention, and

Fig. 2 shows a preferred embodiment of an optical coupling element in accordance with the invention.

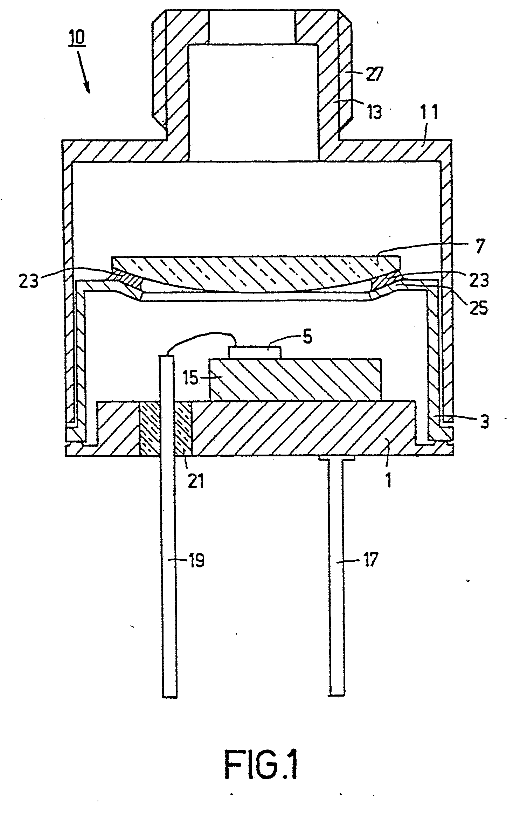

The coupling element 10 shown in Fig. 1 comprises a support 1, a cover 3, a light-emitting diode 5, a lens 7 and a housing 11. The cover 3 which is shaped as a bush is connected to the support 1 by way of a conventional welded joint (resistance weld). Via a cooling block 15, the diode 5 is mounted on the support 1 by means of a method which is known from the manufacture of semiconductors. Also connected to the support 1 is a connection wire 17 which is electrically connected to the diode 5 via the support 1 and the cooling block 15. A further connection wire 19 is electrically insulated from the support 1, via a glass passage 21, and is also connected to the (light source) diode 5. The lens 7 is mounted on a flange 25 of the cover 3 by way of a plastic solder layer 23 of indium. As a result, the lens 7 can be displaced in a direction towards the light source and in a plane perpendicular to this direction, the indium layer 23 then being plastically deformed whilst the coupling element 10 remains hermetically sealed. The edge of the lens 7 is provided with a solderable silver layer or with an other solderable metal layer by way of a silkscreening method, so that the lens 7 can be connected to the flange 25 of the cover 3 by way of an indium solder layer 23.

The lens 7 can alternatively be provided with a bonding layer such as titanium or chromium and subsequently with a solderable layer, such as platinum or nickel, by means of a known sputter technique.

The housing 11 is mounted on the cover 3 by means of an epoxy resin. This can be simply performed, because the solvents of the epoxy resin cannot penetrate the hermetically sealed space in which the light source is accommodated. The housing 11 serves to protect the lens 7 against collisions and damage. Alternatively, the housing 11 can be mounted on the cover 3 by means of a clamp fit. The housing 11 is provided with thread 27 at an end 13 whereto further optical elements can be secured.

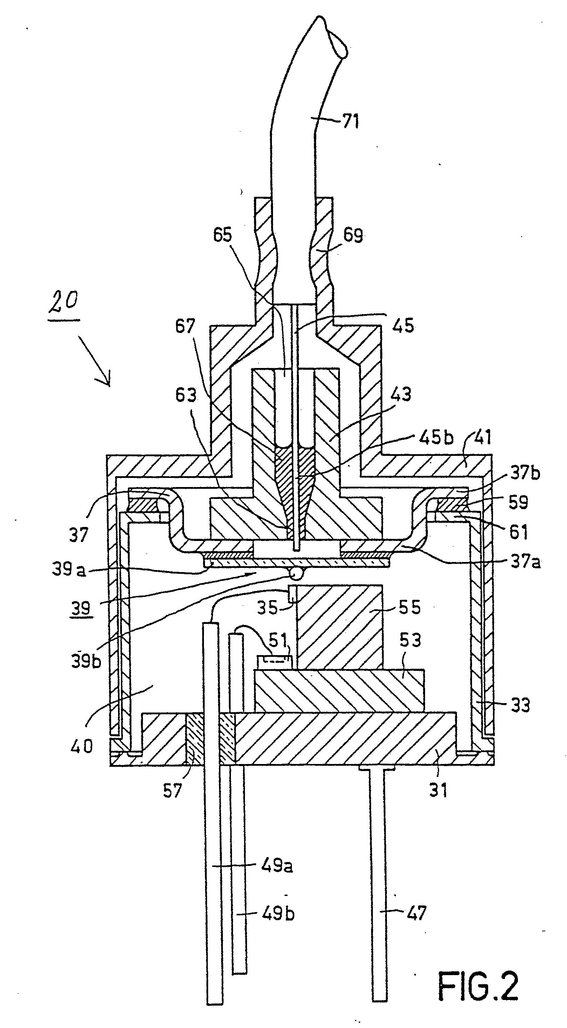

Fig. 2 shows a preferred embodiment of a coupling element 20 in accordance with the invention. The coupling element 20 comprises a support 31, a bush-shaped cover 33, a light source 35 in the form of a semiconductor laser, an annular holder 37, a lens 39, a housing 41 and a support 43 for an end of an optical fibre 45. The coupling element 20 furthermore comprises connection wires 47, 49a and b whereto the semiconductor laser diode 35 and a light-sensitive semiconductor diode 51 are connected. The diode 51 measures the amount of light emitted on one side of the laser diode 35, so that the signal generated by the diode 51 can be used for controlling the emission of the laser diode 35. The connection wire 47 electrically contacts, via the support 31, the heat distribution block 55 and the cooling block 53, the diodes 35 and 51 which are also connected to the connection wires 49a and 49b, respectively. The connection wires 49a and 49b are secured in the support 31 by way of electrically insulating glass passages 57 (only one is shown).

The coupling element 20 is assembled as follows. The glass plate 39a and the holder 37 are simultaneously mounted on the flange 37b of the holder 37 and on the flange 61 of the cover 31, respectively, by means of an indium solder layer. Subsequently, the lens 39b is cemented to the glass plate 39a by means of an epoxy resin. Obviously, the refractive indices of the glass plate 39a, the lens 39b and the epoxy resin are attuned to one another. The lens 39b is secured only after realization of the soldered connections between the flanges 51 and 37b, the glass plate 39a and the flange 37a, so that the epoxy resin will not be discoloured by the soldering heat. Subsequently, the epoxy resin is cured and degased. The assembly formed by the cover 33, the holder 37 and the lens 39 is secured to the support 31 by means of a known resistance weld. The lens 39 comprises a flat glass plate 39a on which a convex lens 39b is cemented by means of an epoxy resin. Therefore, the epoxy resin should be completely cured before the lens 39 with the holder 37 and the cover 33 is mounted on the support 31, in order to ensure that the space 40 enclosed by the support 31, the cover 33, the holder 37 and the lens 39, is not contaminated by gases released from the epoxy resin during curing. The thickness of the indium solder layer 59 should exceed 0.1 mm and be less than 2 mm, but is preferably between 0.5 and 1 mm. Preferably, there is a clearance of some tenths of a millimetre all around the holder 37 with respect to the cover 33. As a result, the convex lens 39b can be placed in the correct position and at the correct distance (in focus) from the laser diode 35 by shifting of and by pressing on the holder 37. The solder layer 59 is then plastically deformed, whilst hermetic sealing of the space 40 is maintained. The space 40 is evacuated or filled with an inert gas such as nitrogen or a noble gas for protection of the diodes 35 and 51. Via an inlet 65, a drop of (setting) glue 67 is introduced into the support 43, after an end 45b of an optical fibre has been slid, via the inlet aperture 65, into the centring aperture 63 (which is shown at an exaggerated scale with respect to the fibre 45). Subsequently, the support 43 is glued to the holder 37 after alignment of the fibre end 45b in the centring aperture 63 with respect to the light beam emerging from the laser diode 35 *via* the lens 39b. Subsequently, the housing 41 is mounted on the cover, for example, by way of a clamping fit or by means of glue. A neck 69 of the housing 41 is constrained by means of a squeezing operation, so that a protective jacket 71 (secondary jacket) is clamped around the optical fibre 45 for strain relief of the fibre 45.

The covers 3, 33 and the holder 37 may be made of, for example, nickel. The supports 1, 31 are made of a nickel/iron alloy, for example, fernico. The housings 11, 41 may be made of brass or aluminium, depending on the function of the housing. When the housing is provided with a thread (27, Fig. 1), brass will preferably be used. When a jacket of an optical fibre (67, Fig. 2) is secured in the housing by squeezing, use will preferably be made of aluminium. Instead of the described indium solder connection 23, 59, use can alternatively be made of other plastic solder connections. Suitable materials in this respect are, for example, lead and metal alloys such as those of indium and/or lead.

## Claims

1. An optical coupling element, comprising a light source and a lens, the light source being mounted on a support on which a cover is secured, the lens being situated opposite the light source which emits a light beam in a direction transversely of the support, characterized in that the cover is shaped as a bush and is connected to the support by way of a metal joint and comprises a flange on which the lens or the flange of an annular metal holder on which the lens is mounted is secured by way of a plastic metal solder layer having a thickness of between 0.1 and 2 mm, the support, the cover and the lens-shaped element forming a hermetically sealed space.

2. A coupling element as claimed in Claim 1, characterized in that the annular holder comprises an annular protrusion on which the lens is mounted, the protrusion and the lens being situated between the flange of the cover and the support.

3. A coupling element as claimed in Claim 1 or 2, characterized in that the solder layer has a thickness of from 0.5 to 1.0 mm.

4. A coupling element as claimed in Claim 1, 2 or 3, characterized in that the solder layer consists of indium.

5. A coupling element as claimed in Claim 1, 2 or 3, characterized in that the solder layer contains an alloy of indium and/or lead.

## Revendications

1. Elément de couplage optique comportant une source lumineuse et une lentille, la source lumineuse étant montée sur une platine sur laquelle est fixé un capot, la lentille étant située en face de la source lumineuse qui émet un faisceau lumineux dans une direction perpendiculaire à la platine, caractérisé en ce que la capot a la forme d'une douille, en ce qu'il est réuni au support par un joint métallique et en ce qu'il comporte une collerette sur laquelle la lentille ou la collerette d'un support métallique annulaire porte- lentille est fixée au moyen d'une couche de soudure métallique plastique ayant une épaisseur comprise entre 0,1 et 2 mm, le capot, la platine et la lentille, ou l'ensemble porte-lentille, formant une enceinte étanche.

2. Elément de couplage selon la revendication 1, caractérisé en ce que le support annulaire présente une protubérance annulaire sur laquelle est fixée la lentille, la protubérance et la lentille étant situées entre la collerette du capot et la platine.

3. Elément de couplage selon l'une quelconque des revendications 1 et 2, caractérisé en ce que la couche de soudure a une épaisseur comprise entre 0,5 mm et 1,0 mm.

4. Elément de couplage selon l'une quelconque des revendications 1, 2 et 3, caractérisé en ce que la couche de soudure est en indium.

5. Elément de couplage selon l'une quelconque des revendications 1, 2 et 3, caractérisé en ce que la couche de soudure contient un alliage à base d'indium et/ou de plomb.

## Patentansprüche

1. Optisches Koppelement mit einer Lichtquelle und einer Linse, wobei die Lichtquelle auf einem Träger montiert ist, auf dem eine Kappe befestigt ist, und wobei die Linse gegenüber der Lichtquelle angeordnet ist, die ein Lichtbündel in einer zum Träger senkrechten Richtung ausstrahlt, dadurch gekennzeichnet, dass die Kappe buchsenförmig und mit dem Träger über eine Metallverbindung verbunden ist und einen Flansch enthält, auf dem die Linse oder der Flansch einer ringförmigen Metallhalterung, auf der die Linse montiert ist, mit Hilfe einer plastischen Metall-Lotschicht mit einer Dicke von 0,1 bis 2 mm befestigt ist, wobei der Träger, die Kappe und das linsenförmige Element einen hermetisch geschlossenen Raum bilden.

2. Verbindungselement nach Anspruch 1, dadurch gekennzeichnet, dass die ringförmige Halterung einen ringförmigen Vorsprung enthält, auf dem die Linse montiert ist, wobei der Vorsprung und die Linse sich zwischen dem Flansch der Kappe und dem Träger befinden.

3. Verbindungselement nach Anspruch 1 oder 2, dadurch gekennzeichnet, dass die Lotschicht eine Dicke von 0,5 bis 1,0 mm hat.

4. Verbindungselement nach Anspruch 1, 2 oder 3, dadurch gekennzeichnet, dass die Lotschicht aus Indium besteht.

5. Verbindungselement nach Anspruch 1, 2 oder 3, dadurch gekennzeichnet, dass die Lotschicht eine Legierung aus Indium und/oder Blei enthält.

FIG.1

FIG.2